# FASCICULE DE BREVET EUROPEEN

(11) **EP 0 430 819 B1**
(45) Date de publication et mention de la délivrance du brevet: **29.09.1993**
(21) Numéro de dépôt: 90403422.0
(22) Date de dépôt: 30.11.1990
(51) Int. Cl.: C04B 35/52, C04B 35/80, C04B 41/87

(54) **Procédé de fabrication d'une pièce en matériau composite, notamment à texture en fibres de carbone ou réfractaires et matrice en carbone ou céramique**
Verfahren zur Herstellung eines Verbundwerkstoffteils, insbesondere mit einer Kohle- oder Feuerfestfaserstruktur und Kohle- oder Keramikmatrix
Method of making a composite material part, especially with carbon or refractory fibres and carbon or ceramic matrix

(30) Priorité: 01.12.1989 FR 8915929
(43) Date de publication de la demande: 05.06.1991
(73) Titulaire: SOCIETE EUROPEENNE DE PROPULSION (S.E.P.) Société Anonyme dite:, 92150 Suresnes (FR)
(72) Inventeur: Patrigeon, Yves, D., F-33200 Bordeaux Cauderan (FR); Vives, Michel C., F-33320 Eysines (FR); Sabaca, Denis M., F-33200 Mérignac (FR)
(74) Mandataire: Joly, Jean-Jacques

(56) Documents cités:
- CH-A- 436 092
- FR-A- 2 587 992
- GB-A- 2 028 230
- US-A- 3 991 248

## Description

La présente invention concerne un procédé de fabrication d'une pièce en un matériau composite comportant une texture fibreuse de renfort densifiée par une matrice.

Plus particulièrement, l'invention concerne un procédé du type comportant la mise en forme de la texture fibreuse de renfort au moyen d'un outillage, et la densification de la texture par infiltration chimique en phase vapeur.

Un tel procédé est utilisé pour la fabrication de pièces en matériaux composites thermostructuraux, c'est-à-dire des matériaux aptes à constituer des éléments de structure et à conserver leurs propriétés mécaniques à des températures élevées.

Les matériaux composites thermostructuraux comprennent notamment les composites de type carbone-carbone (C-C) et les composites à matrice céramique (CMC).

Dans un composite de type C-C, la texture de renfort est en fibres de carbone et est densifiée par du carbone, tandis que, dans un composite de type CMC, la texture de renfort est en fibres réfractaires (carbone ou céramique) et est densifiée par une matrice céramique.

Lorsque des pièces en matériau composite thermostructural sont fabriquées par infiltration chimique en phase vapeur du matériau constitutif de la matrice, au sein de la porosité accessible de la texture de renfort, celle-ci est généralement maintenue en forme par un outillage, habituellement en graphite.

Un problème qui se pose depuis longtemps est celui du démoulage de la pièce densifiée en raison de l'adhésion à l'outillage. Cette adhésion est due au matériau constitutif de la matrice qui se dépose à la fois au sein de la porosité de la texture de renfort et à la surface de l'outillage.

Différentes solutions ont été proposées pour réduire l'adhésion à l'outillage, notamment par traitement de surface de celui-ci.

Toutefois, les solutions connues ont une efficacité limitée, en particulier dans le cas de textures de renfort fibreux de type tridimensionnel (3D). Par rapport aux textures de type bidimensionnel (2D), dont les fibres s'étendent parallèlement aux faces de la texture, les textures 3D comportent des fibres qui s'étendent dans des directions formant un angle non nul par rapport aux faces de la texture. Ces fibres, qui débouchent sur chaque face de la texture, offrent de multiples points de contact avec l'outillage, favorisant l'adhésion. Cette adhésion est d'autant plus forte que la texture est foisonnante en surface.

Aussi, la présente invention a-t-elle pour but de fournir un procédé qui permette un démoulage aisé des pièces obtenues après densification par infiltration en phase vapeur d'une texture fibreuse dans un outillage, même lorsqu'il s'agit d'une texture de type type 3D.

La présente invention a aussi pour but de fournir un procédé qui permette la densification simultanée de plusieurs textures superposées dans un même outillage.

Ce but est atteint au moyen d'un procédé du type défini en tête de la présente description et dans lequel, conformément à l'invention, avant densification, une strate d'interposition est disposée entre la texture de renfort et au moins une structure adjacente constituée par un élément d'outillage ou une autre texture fibreuse à densifier simultanément, la strate d'interposition étant en un tissu réalisé en un matériau réfractaire ayant un coefficient de dilatation différent de celui du matériau constitutif de la texture, de sorte qu'après densification de la texture, la séparation entre celle-ci et la structure adjacente est favorisée par l'effet des dilatations différentielles à l'interface entre la texture et la strate d'interposition.

La strate d'interposition est de préférence constituée par une couche de tissu, telle qu'un satin ou une toile, dont l'objet est de minimiser les points de contact entre la texture et la structure adjacente, c'est-à-dire l'outillage ou une autre texture.

L'effet combiné de la réduction des points de contact et des dilatations différentielles entre la texture et la strate d'interposition amène, pendant la phase de refroidissement succédant à l'infiltration, des ruptures naturelles de la matrice au niveau des zones d'interface texture-strate d'interposition.

L'utilisation de strates d'interposition permet de réaliser la densification simultanée de plusieurs textures superposées dans un même outillage. A cet effet, les textures adjacentes sont séparées l'une de l'autre par une strate d'interposition, les faces externes des textures superposées étant, le cas échéant, chacune séparées de l'outillage par une strate d'interposition.

L'invention sera mieux comprise à la lecture de la description faite, ci-après, à titre indicatif mais non limitatif, en référence aux dessins annexés sur lesquels :
- la figure 1 montre très schématiquement une texture de renfort fibreuse montrée dans un outillage en étant séparée de celui-ci par deux strates d'interposition, conformément à l'invention ;
- la figure 2 est une vue de détail montrant très schématiquement, de façon agrandie, des zones voisines de l'outillage et de la texture séparées par une strate d'interposition ;
- les figures 3 et 4 illustrent très schématiquement des textures de renfort utilisables pour la mise en oeuvre du procédé conforme à l'invention, et
- les figures 5 et 6 illustrent l'application du procédé selon l'invention à la fabrication simultanée de plusieurs pièces par densification de plusieurs textures superposées dans l'outillage.

La description qui suit est faite dans le cadre de la réalisation de pièces en matériau composite C-C ou en CMC, ce qui constitue le domaine d'application privilégié de l'invention.

De façon bien connue en soi, ces pièces sont réalisées par formation d'une texture de renfort fibreuse 10 (ou préforme), mise en place de la texture dans un outillage comprenant un poinçon 12 et une matrice 14 et densification de la texture fibreuse par infiltration en phase vapeur du matériau constitutif de la matrice du matériau composite. Ces processus sont décrits notamment dans le document US-A-3 895 084 pour la fabrication de pièces en composite C-C, et dans le document FR-A-2 401 888 pour la fabrication de pièces en CMC.

La texture 10 est en fibres réfractaires choisies par exemple parmi les fibres en carbone et les fibres en céramique (carbure de silicium, nitrure de bore, alumine, zircone, ...).

La texture 10 est par exemple formée par un empilement de couches ou strates bidimensionnelles, par exemple en tissu, qui sont maintenues entre le poinçon 12 et la matrice 14 en étant comprimées pour obtenir dans la texture à densifier, un taux volumique de fibres désiré.

Les couches empilées peuvent être liées entre elles au moyen de fibres formant un angle non nul par rapport aux faces de la texture.

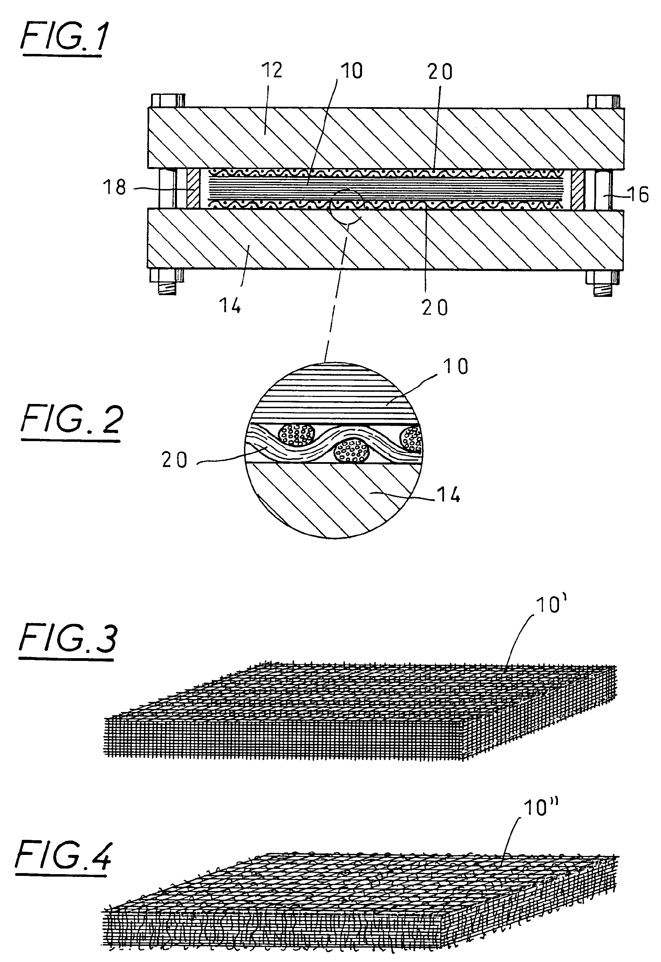

Ainsi, la figure 3 montre une texture 10' avec des fils implantés perpendiculairement aux couches empilées, l'implantation étant par exemple réalisée selon le procédé décrit dans le document FR-A-2 565 262.

La figure 4 montre une autre texture 10" dans laquelle les couches de tissu sont liées entre elles par des fibres qui traversent les couches par suite de l'aiguilletage d'un voile de fibres. Dans le cas d'une texture en fibres de carbone, le voile de fibres est constitué par exemple par des fibres en PAN (polyacrylonitrile) préoxydé, précurseur du carbone, qui subissent ensuite une carbonisation.

L'outillage dans lequel est mise en place la texture de renfort est généralement en graphite. Le poinçon 12 et la matrice 14 sont percés d'une pluralité de trous afin de faciliter l'accès à la texture à densifier par le mélange gazeux d'infiltration. Celui-ci est choisi en fonction de la nature du matériau constitutif de la matrice (carbone ou céramique telle que carbure de silicium, nitrure de bore, ...). Un revêtement intermédiaire en pyrocarbone ou nitrure de bore pourra être déposé sur les fibres avant infiltration de la matrice, comme décrit dans le document FR-A-2 567 874. Il est par ailleurs possible de réaliser une matrice ayant plusieurs phases formées par dépôts successifs de matériaux différents.

Dans l'exemple illustré, le poinçon 12 et la matrice 14 ont la forme de simples plaques. Bien entendu, l'outillage pourra présenter toute autre forme, par exemple des plateaux incurvés, en fonction de la forme de la pièce à réaliser.

Le poinçon 12 et la matrice 14 sont reliés l'un à l'autre au moyen de tirants 16 qui permettent la mise en compression de la texture. Des entretoises 18 définissant l'épaisseur de la texture à densifier peuvent être insérées entre le poinçon et la matrice.

Lorsque la densification est réalisée avec un contact direct entre la texture et l'outillage, des difficultés sont rencontrées au démoulage par suite de l'adhésion de la texture à l'outillage, en particulier lorsque la texture présente des fibres qui font saillie ou qui foisonnent sur ses faces, comme c'est le cas des textures des figures 3 et 4.

Pour résoudre ce problème, une strate d'interposition 20 est disposée entre la texture et chaque face de l'outillage adjacente à la texture.

La strate d'interposition 20 (figures 1 et 2) est avantageusement constituée par une couche de tissu, et est réalisée en un matériau ayant un coefficient de dilatation thermique différent de celui du matériau constitutif de la texture. La densification par infiltration chimique en phase vapeur étant réalisée à une température relativement élevée, la différence de dilatations se traduit, pendant la phase de refroidissement suivant l'infiltration, par des ruptures au niveau des zones d'interface texture-strate d'interposition co-infiltrées par la matrice.

Ainsi, lorsque la texture à densifier est en carbone, on peut utiliser une strate d'interposition en un tissu de fibres réfractaires autres que le carbone, par exemple un tissu en carbure de silicium, tandis que, lorsque la texture à densifier est en céramique ou autre matériau réfractaire différent du carbone, on peut utiliser une strate d'interposition en un tissu de fibres en carbone.

En raison de la présence de la strate d'interposition 20, un contact entre des fibres faisant saillie ou foisonnant à la surface de la texture de renfort et l'outillage est évité ou, au moins, fortement réduit.

L'utilisation de strates d'interposition offre en outre la possibilité de densifier plusieurs textures de renfort superposées dans un même outillage.

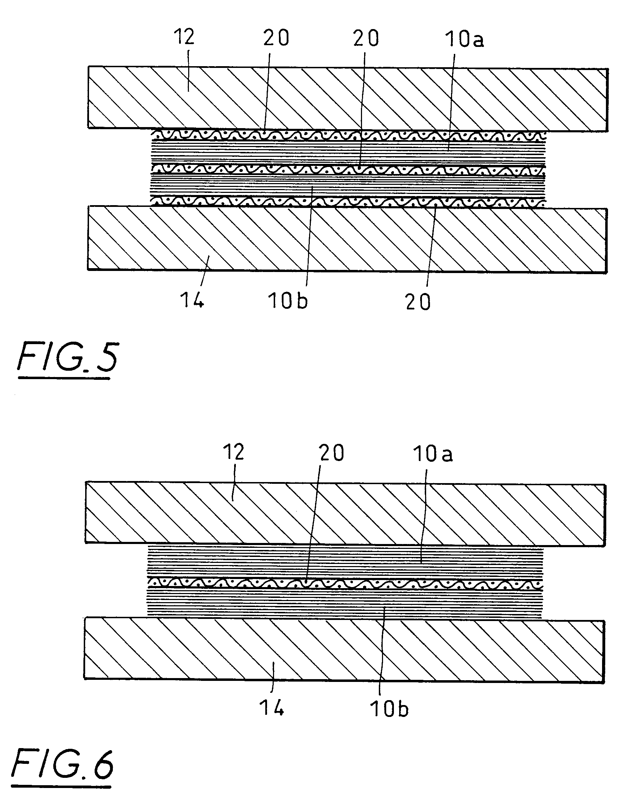

Ainsi, la figure 5 montre un outillage analogue à celui de la figure 1 avec un poinçon 12 et une matrice 14 entre lesquels sont disposées deux textures de renfort fibreux 10a et 10b ayant sensiblement les mêmes dimensions.

Des strates d'interposition 20 sont disposées entre le poinçon 12 et la texture adjacente 10a, entre la matrice 14 et la texture adjacente 10b et entre les textures 10a et 10b. La strate d'interposition située entre les textures agit de la même façon que celle située entre chaque texture et l'outillage, pour permettre une séparation aisée des pièces obtenues après co-densification des textures 10a et 10b.

Le nombre de textures pouvant être superposées dans un même outillage n'est pas limité à deux, les textures voisines étant séparées par une strate d'interposition.

Bien entendu, le matériau constitutif d'une strate d'interposition disposée entre deux textures est choisi de manière à présenter un coefficient de dilatation thermique différent de celui, ou de ceux, du ou des matériaux constitutif(s) des deux textures.

Dans le cas où le collage entre texture à densifier et outillage est nul ou insuffisant pour gêner de façon significative l'opération de démoulage, le procédé conforme à l'invention peut être simplement utilisé pour densifier de façon simultanée plusieurs textures dans un même outillage.

Comme le montre la figure 6, une strate d'interposition 22 est disposée entre deux textures 10a et 10b superposées entre le poinçon 12 et la matrice 14, mais aucune strate d'interposition n'est prévue entre les textures et l'outillage.

Ainsi, dans les cas illustrés par les figures 5 et 6, plusieurs pièces peuvent être densifiées simultanément au moyen d'un seul et même outillage, ce qui constitue à l'évidence un avantage du point de vue du rendement de fabrication.

## Revendications

1. Procédé de fabrication d'une pièce en matériau composite comportant une texture fibreuse de renfort densifiée par une matrice, procédé comprenant la mise en forme de la texture fibreuse de renfort au moyen d'un outillage, et la densification de la texture par infiltration chimique en phase vapeur du matériau constitutif de la matrice au sein de la porosité de la texture,
caractérisé en ce que, avant densification, une strate d'interposition est disposée entre la texture de renfort et au moins une structure adjacente constituée par un élément d'outillage ou une autre texture fibreuse à densifier simultanément, la strate d'interposition étant un tissu réalisé en un matériau réfractaire ayant un coefficient de dilatation différent de celui du matériau constitutif de la texture, de sorte qu'après densification de la texture, la séparation entre celle-ci et la structure adjacente est favorisée par l'effet des dilatations différentielles à l'interface entre la texture et la strate d'interposition.

2. Procédé selon la revendication 1, pour la fabrication d'une pièce en matériau composite comprenant une texture de renfort en fibres de carbone, caractérisé en ce que la strate d'interposition est en un tissu de fibres de céramique.

3. Procédé selon la revendication 2, caractérisé en ce que la strate d'interposition est en un tissu de fibres de carbure de silicium.

4. Procédé selon la revendication 1 pour la fabrication d'une pièce en matériau composite comprenant une texture de renfort en fibres céramiques, caractérisé en ce que la strate d'interposition est en un tissu de fibres de carbone.

## Patentansprüche

1. Verfahren zur Herstellung eines Verbundwerkstoffteils, das eine Verstärkungsfaserstruktur aufweist, die durch eine Matrix verdichtet ist, bei dem die Verstärkungsfaserstruktur mittels eines Werkzeugs geformt, und die Verdichtung der Struktur durch chemische Infiltration in der Dampfphase des Werkstoffbestandteils der Matrix innerhalb der Porosität der Struktur erfolgt,
dadurch gekennzeichnet, daß vor der Verdichtung eine Zwischenschicht zwischen der Verstärkungsstruktur und wenigstens einer benachbarten Struktur, die von einem Werkzeugelement oder einer weiteren, gleichzeitig zu verdichtenden Faserstruktur gebildet wird, angeordnet wird, wobei die Zwischenschicht ein Gewebe ist, das aus wärmefesten Material hergestellt ist, das einen Expansionskoeffizienten hat, der von dem des Werkstoffbestandteils der Struktur verschieden ist, so daß nach der Verdichtung der Struktur die Trennung zwischen dieser und der benachbarten Struktur und der Zwischenschicht begünstigt wird.

2. Verfahren nach Anspruch 1 zur Herstellung eines Verbundwerkstoffteils, das eine Verstärkungsstruktur aus Kohlestoffasern aufweist, dadurch gekennzeichnet, daß die Zwischenschicht ein Keramikfasergewebe ist.

3. Verfahren nach Anspruch 1, dadurch gekennzeichnet, daß die Zwischenschicht aus Siliziumkarbidfasern besteht.

4. Verfahren nach Anspruch 1 zur Herstellung eines Verbundwerkstoffteils, das eine Verstärkungsstruktur aus Keramikfasern aufweist, dadurch gekennzeichnet, daß die Zwischenschicht aus einem Kohlenstoffasergewebe besteht.

## Claims

1. Method for manufacturing a composite material part containing a fibrous reinforcement texture densified by a matrix, which method comprises the steps of shaping the fibrous reinforcement texture by means of a tool, and of densifying the texture by chemical vapor infiltration of the material constituting the matrix through the porosity of the texture,
characterized in that, before densification, an inserted layer is placed between the reinforcement texture and at least one adjacent structure constituted by a tool or another fibrous texture to be simultaneously densified, the inserted layer being a cloth made from a refractory material having a coefficient of expansion different from that of the material constituting the texture, such that after densification of the texture, the separation between said texture and the adjacent structure is helped by the effect of the differential expansions at the interface between the texture and the inserted layer.

2. Method according to claim 1, for manufacturing a composite material part including a reinforcement texture in carbon fibers, characterized in that the inserted layer is a cloth of ceramic fibers.

3. Method according to claim 2, characterized in that the inserted layer is a cloth of silicon carbide fibers.

4. Method according to claim 1, for manufacturing a composite material part including a reinforcement texture in ceramic fibers, characterized in that the inserted layer is a cloth of carbon fibers.
